# EUROPEAN PATENT APPLICATION

(11) **EP 4 148 500 A1**
(43) Date of publication of application: **15.03.2023**
(21) Application number: 21804465.9
(22) Date of filing: 14.04.2021
(51) Int. Cl.: G03F 9/00

(54) **DRAWING METHOD, DRAWING DEVICE, AND PROGRAM**

(30) Priority: 09.05.2020 JP 2020082908
(71) Applicant: Inspec Inc., Senboku City Akita, 014-0341 (JP)
(72) Inventor: SUGAWARA, Masashi, Senboku City, Akita 0140341 (JP)
(74) Representative: Hasegawa, Kan
(86) International application number: PCT/JP2021/015515
(87) International publication number: WO 2021/229992

(57) **Abstract**

A drawing method, etc. are provided that can reduce the amount of data in the drawing data used when drawing a continuous long wiring pattern on a substrate. The wiring pattern includes first regions, in which a pattern in the width direction of the substrate changes in the longitudinal direction of the substrate, and second regions, in which a pattern in the width direction does not change in the longitudinal direction. The drawing data for drawing the wiring pattern includes two-dimensional image data representing a two-dimensional pattern of the first regions, one-dimensional image data representing a one-dimensional pattern in the width direction of the second regions, and information representing lengths in the longitudinal direction of the second regions. The method comprises: drawing the pattern of the first regions on the substrate by scanning the beam based on the two-dimensional image data and conveying the substrate; and drawing the pattern of the second regions on the substrate by repeatedly irradiating the substrate with the beam in the one-dimensional pattern based on the one-dimensional image data and conveying the substrate based on the information representing lengths.

## Description

### TECHNICAL FIELD

The present invention relates to drawing methods, drawing devices, and programs for drawing wiring patterns on flexible substrates.

### BACKGROUND ART

In recent years, the amount of electronics used in transportation machines such as automobiles and aircraft has been steadily increasing. Along with this, the number of wire harnesses used for power supply and/or signal transmission and reception with respect to the electronics is also increasing. On the other hand, weight reduction and internal space saving are required in the transportation machines, and an increase in weight and space occupation due to the increase of the wire harnesses is therefore becoming a problem.

In view of these problems, investigations have been made to replace the wire harnesses used in transportation machines with long sheet-like flexible printed circuits (FPCs) having flexibility.

As a technique for forming patterns on a long sheet-like substrate, for example, NPTL 1 discloses a technique of performing alignment measurement, overlay exposure and workpiece replacement in parallel, in order to perform a process while continuously conveying the film by a roll-to-roll method without stopping the film from being conveyed.

In addition, PTL 1 discloses a maskless exposure apparatus including: exposure means including an optical modulation element array; substrate holding means for holding a part in a longitudinal direction of a long substrate into a flat state; relative traveling means for relatively traveling the exposure means and the substrate holding means in the longitudinal direction of the long substrate; data storage means for storing a division exposure pattern data prepared by dividing long exposure pattern data corresponding to the long substrate, in the longitudinal direction of the long substrate; and exposure control means for controlling the exposure means to expose the long substrate in accordance with the division exposure pattern data stored in the data storage means, while relatively travelling the exposure means and the substrate holding means by the relative traveling means. In this PTL 1, the division exposure pattern data for one exposure step is created based on the long exposure pattern data, and in doing so, the division exposure pattern data is created so that the division exposure patterns overlap in the overlap sections. Then, the exposure unit is driven based on this division exposure pattern data in order to expose the long substrate to the division exposure patterns.

### PRIOR ART DOCUMENTS

### PATENT LITERATURE

PTL 1: JP2016-224301 A

### NON-PATENT LITERATURE

NPTL 1: Yoshiaki Kito, et al., "Direct Imaging Exposure Equipment with High Overlay Accuracy for Flexible Substrate in Roll-to-Roll Method," Journal of the Institute of Image Information and Television Engineers, Vol. 71, No. 10, pp. J230-J235 (2017), the Institute of Image Information and Television Engineers, September 8, 2017

### SUMMARY OF THE INVENTION

### PROBLEMS TO BE SOLVED BY THE INVENTION

For example, in order to replace the wire harnesses used in a transportation machine, such as an automobile, with FPCs, it is necessary to form a continuous wiring pattern of several meters in length (e.g., 6 m or more) on a substrate. When exposing the substrate to such a continuous long pattern, the amount of data in the drawing data is enormous.

The present invention has been made in view of the above, and an object of the present invention is to provide a drawing method, a drawing device, and a program that can reduce the amount of data in the drawing data used when drawing a long wiring pattern on a substrate.

### MEANS FOR SOLVING THE PROBLEMS

In order to solve the above-described problems, the drawing method, which is an aspect of the present invention, is a drawing method to be executed by a drawing device for drawing a wiring pattern by irradiating a substrate having a long sheet shape with a beam for exposure while conveying the substrate in a longitudinal direction of the substrate. The drawing device includes: conveying means that conveys the substrate along the longitudinal direction; and at least one head for exposure that is provided opposite to part of a region of the substrate to be conveyed by the conveying means and that emits a beam for exposure toward the part of the region of the substrate. The wiring pattern includes first regions, in which a pattern in a width direction orthogonal to the longitudinal direction changes in the longitudinal direction, and second regions, in which a pattern in the width direction does not change in the longitudinal direction. Drawing data for drawing the wiring pattern includes two-dimensional image data representing a two-dimensional pattern of the first regions, one-dimensional image data representing a one-dimensional pattern in the width direction of the second regions, and information representing lengths in the longitudinal direction of the second regions. The method includes: drawing the pattern of the first regions on the substrate by scanning the beam in the width direction based on the two-dimensional image data and conveying the substrate; and drawing the pattern of the second regions on the substrate by repeatedly irradiating the substrate with the beam in the one-dimensional pattern in the width direction based on the one-dimensional image data and conveying the substrate for a length determined based on the information representing lengths.

In the above-described drawing method, the two-dimensional image data may be a two-dimensional bitmap data, the one-dimensional image data may be one-dimensional bitmap data, and the information representing lengths may be attached to a header of the one-dimensional bitmap data.

In the above-described drawing method, the conveying means may have a cylindrical shape, and include a conveying drum that supports the substrate on part of a region of an outer periphery and conveys the substrate by rotating about a central shaft of the cylinder, and the conveying drum may rotate for a time or a rotation angle, which is determined based on the information representing lengths, while the beam is repeatedly applied based on the one-dimensional image data.

The above-described drawing method may include: reading image data included in the drawing data for drawing the wiring pattern for each region included in the wiring pattern; determining whether the read image data is either the two-dimensional image data or the one-dimensional image data; and drawing the pattern of the first regions or the second regions depending on the result of the determination.

The drawing device, which is another aspect of the present invention, is a drawing device for drawing a wiring pattern by irradiating a substrate having a long sheet shape with a beam for exposure while conveying the substrate in a longitudinal direction of the substrate. The drawing device includes: conveying means that conveys the substrate along the longitudinal direction; and at least one head for exposure that is provided opposite to part of a region of the substrate to be conveyed by the conveying means and that emits a beam for exposure toward the part of the region of the substrate, a storage part that stores drawing data for drawing the wiring pattern on the substrate; and a control part that controls operations of the at least one head for exposure and the conveying means based on the drawing data. The wiring pattern includes first regions, in which a pattern in a width direction orthogonal to the longitudinal direction changes in the longitudinal direction, and second regions, in which a pattern in the width direction does not change in the longitudinal direction. Drawing data includes two-dimensional image data representing a two-dimensional pattern of the first regions, one-dimensional image data representing a one-dimensional pattern in the width direction of the second regions, and information representing lengths in the longitudinal direction of the second regions. The control part performs the control of executing: a first drawing operation of drawing the pattern of the first regions on the substrate by scanning the beam in the width direction based on the two-dimensional image data and conveying the substrate, and a second drawing operation of drawing the pattern of the second regions on the substrate by repeatedly irradiating the substrate with the beam in the one-dimensional pattern in the width direction based on the one-dimensional image data and conveying the substrate for a length determined based on the information representing lengths.

The drawing program, which is another aspect of the present invention, is a drawing program to be executed by a drawing device for drawing a wiring pattern by irradiating a substrate having a long sheet shape with a beam for exposure while conveying the substrate in a longitudinal direction of the substrate. The drawing device includes: conveying means that conveys the substrate along the longitudinal direction; and at least one head for exposure that is provided opposite to part of a region of the substrate to be conveyed by the conveying means and that emits a beam for exposure toward the part of the region of the substrate. The wiring pattern includes first regions, in which a pattern in a width direction orthogonal to the longitudinal direction changes in the longitudinal direction, and second regions, in which a pattern in the width direction does not change in the longitudinal direction. Drawing data for drawing the wiring pattern includes two-dimensional image data representing a two-dimensional pattern of the first regions, one-dimensional image data representing a one-dimensional pattern in the width direction of the second regions, and information representing lengths in the longitudinal direction of the second regions. The drawing program causes the execution of: a first drawing step of drawing the pattern of the first regions on the substrate by scanning the beam in the width direction based on the two-dimensional image data and conveying the substrate; and a second drawing operation of drawing the pattern of the second regions on the substrate by repeatedly irradiating the substrate with the beam in the one-dimensional pattern in the width direction based on the one-dimensional image data and conveying the substrate for a length determined based on the information representing lengths.

### EFFECT OF THE INVENTION

According to the present invention, regarding the second regions of the wiring pattern where the pattern in the width direction of the substrate does not change in the longitudinal direction, the drawing is performed based on the one-dimensional image data representing the one-dimensional pattern in the width direction of the substrate and the information representing the lengths in the longitudinal direction of the second regions, the amount of data in the drawing data related to the second regions can therefore be reduced. Thus, the amount of data in the drawing data used when drawing a continuous long wiring pattern on a substrate can be reduced as a whole.

### BRIEF DESCRIPTION OF THE DRAWINGS

[FIG. 1] FIG. 1 is a schematic diagram showing a schematic configuration of a drawing device according to an embodiment of the present invention.
[FIG. 2] FIG. 2 is a plan view of the drawing device shown in FIG. 1.
[FIG. 3] FIG. 3 is a schematic diagram showing a schematic configuration of the inside of an exposure head shown in FIG. 1.
[FIG. 4] FIG. 4 is a schematic diagram of the exposure head shown in FIG. 1 as seen from the substrate side.
[FIG. 5] FIG. 5 is a block diagram showing a schematic configuration of a controller shown in FIG. 1.
[FIG. 6] FIG. 6 is a schematic diagram illustrating a wiring pattern to be drawn on a substrate.
[FIG. 7] FIG. 7 is a schematic diagram illustrating one-dimensional patterns in the width direction of second regions.
[FIG. 8] FIG. 8 is a flowchart showing a drawing method according to an embodiment of the present invention.

### EMBODIMENTS OF THE INVENTION

Hereinafter, a drawing method, a drawing device, and a drawing program according to embodiments of the present invention will be described with reference to the drawings. It should be noted that the present invention is not limited by these embodiments. In the description of each drawing, the same parts are denoted by the same reference numbers.

The drawings referred to in the following description are merely schematic representations of shape, size, and positional relationship to the extent that the subject matter of the present invention may be understood. In other words, the present invention is not limited only to the shapes, sizes, and positional relationships illustrated in the respective figures. In addition, the drawings may also include, among themselves, parts having different dimensional relationships and ratios from each other.

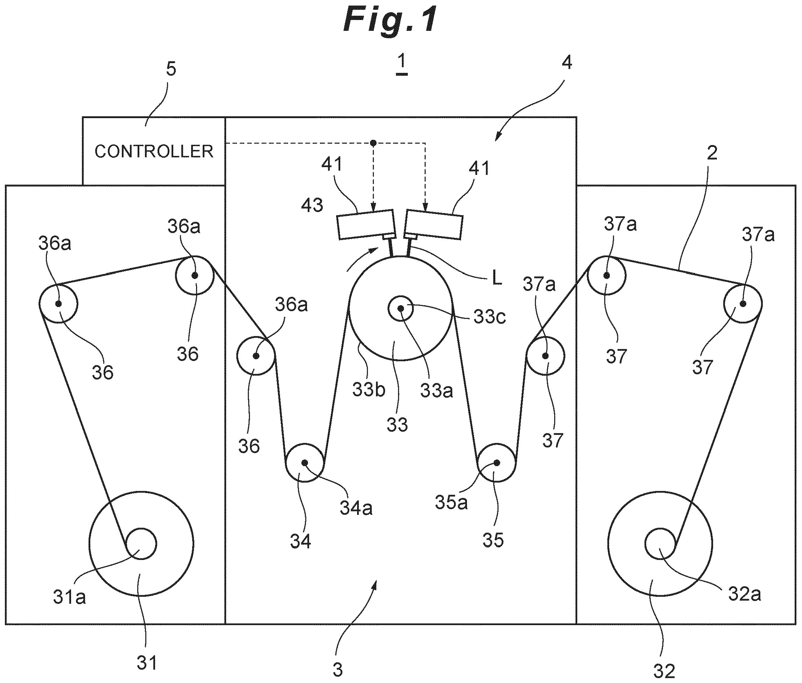

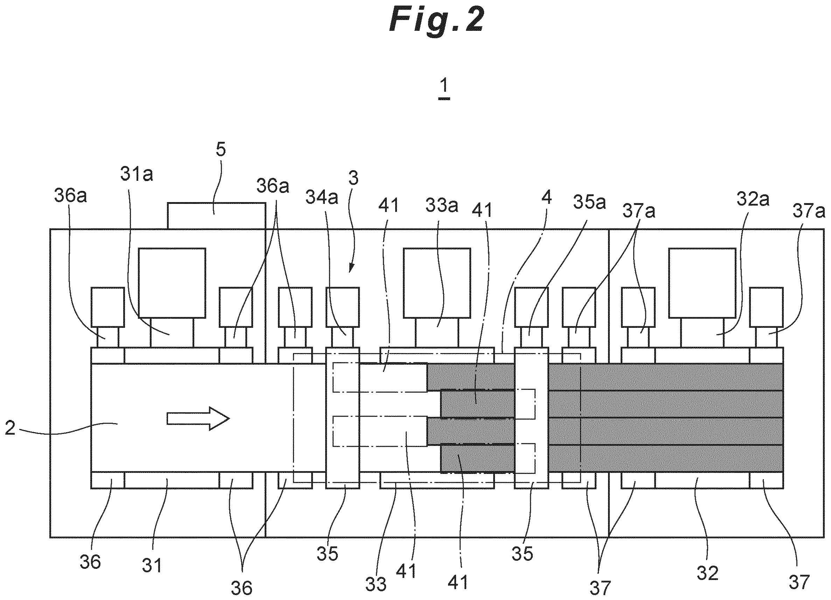

FIG. 1 is a schematic diagram showing a schematic configuration of a drawing device according to an embodiment of the present invention. FIG. 2 is a plan view of the drawing device. As shown in FIGS. 1 and 2, the drawing device 1 includes a conveying system 3 for conveying a substrate 2 having a long sheet shape, an exposure unit 4 for irradiating the substrate 2 with beams L for exposure, and a controller 5 for controlling the operation of the conveying system 3 and the exposure unit 4. The drawing device 1 is a so-called direct exposure drawing device that draws the wiring pattern directly on the substrate 2 by scanning the beams L.

In the present embodiment, a flexible printed circuit (FPC) is used as the substrate 2 to be processed. The FPC is a flexible substrate in which a metal foil such as copper is bonded to a base film made of an insulating resin such as polyimide. The substrate 2 is, for example, a strip-shaped FPC of several meters to several tens of meters in length, and the substrate is unwound from a state of being wound in a roll on an unwinding reel 31, and is wound around on a take-up reel 32 after being conveyed by the conveying system 3 and being provided with a pattern by the exposure unit 4. Thus, this method of conveying in which the strip-shaped workpiece is unwound from a roll and wound around a roll after application of predetermined processing is referred to as a "roll-to-roll" method.

In the conveying system 3, a rotary shaft 31a for rotatably supporting the unwinding reel 31, a rotary shaft 32a for rotatably supporting the take-up reel 32, a conveying drum 33, tension pulleys 34, 35 provided respectively on the upstream side (left side in the figure) and the downstream side (right side in the figure) of the conveying drum 33, and a plurality of guide rollers 36, 37 are provided.

The conveying drum 33 generally has a cylindrical shape and is supported by a rotary shaft 33a which rotates by the rotational driving force supplied from a drive source. The conveying drum 33 supports the substrate 2 in a region of substantially the upper half of the outer periphery 33b thereof, and conveys the substrate 2 as the conveying drum rotates. Further, the conveying drum 33 is provided with an encoder 33c for measuring the amount of rotation of the conveying drum 33.

Two tension pulleys 34, 35 are located below the conveying drum 33 and are located such that they are movable in the vertical direction. In particular, the tension pulleys 34, 35 are respectively rotatably supported on rotary shafts 34a, 35a which are movable in the vertical direction. A tension adjusting mechanism for biasing the rotary shaft 34a, 35a downward is coupled to each rotary shaft 34a, 35a. The substrate 2 wound around the conveying drum 33 can be conveyed with a predetermined tension applied thereon by biasing the tension pulleys 34, 35 downward via the rotary shafts 34a, 35a by means of the tension adjusting mechanism.

Each guide roller 36 is rotatably supported on a rotary shaft 36a and guides the substrate 2 unwound from the unwinding reel 31 to the upstream-side tension pulley 34. Each guide roller 37 is rotatably supported on a rotary shaft 37a and guides the substrate 2, on which a pattern has been drawn, from the downstream-side tension pulley 35 to the take-up reel 32.

It should be noted that, the means for conveying the substrate 2 is not limited to the configurations of the conveying system 3 shown in FIGS. 1 and 2, as long as the pattern can be drawn onto the substrate 2 while the substrate 2 is conveyed in the roll-to-roll method. For example, a region where the substrate 2 is held in a planar state may be provided between the unwinding reel 31 and the take-up reel 32, and the drawing may be performed on the substrate 2 in this planar- region. Further, with respect to the conveying system 3 shown in FIGS. 1 and 2, a unit (a pre-processing unit, a post-processing unit, etc.) may be provided for performing different processing between unwinding of the substrate 2 from the unwinding reel 31 and reaching thereof to the conveying drum 33, or between removal of the substrate 2 from the conveying drum 33 and winding thereof on the take-up reel 32. Typically, an edge position control (EPC) device is provided which detects the edge position of the substrate 2 and finely moves the unwinding device or the take-up device in the conveying system 3 in order to prevent meandering during conveying of the substrate.

The exposure unit 4 includes one or more exposure heads 41 (four in the embodiment) that emit beams L for exposure. Each exposure head 41 is provided opposite to a region of part of the conveyed substrate 2 (part of the substrate 2 supported by the conveying drum 33 in the present embodiment), and directly draws a pattern, such as a circuit or a wiring, on the substrate 2 by irradiating this region with the beams L.

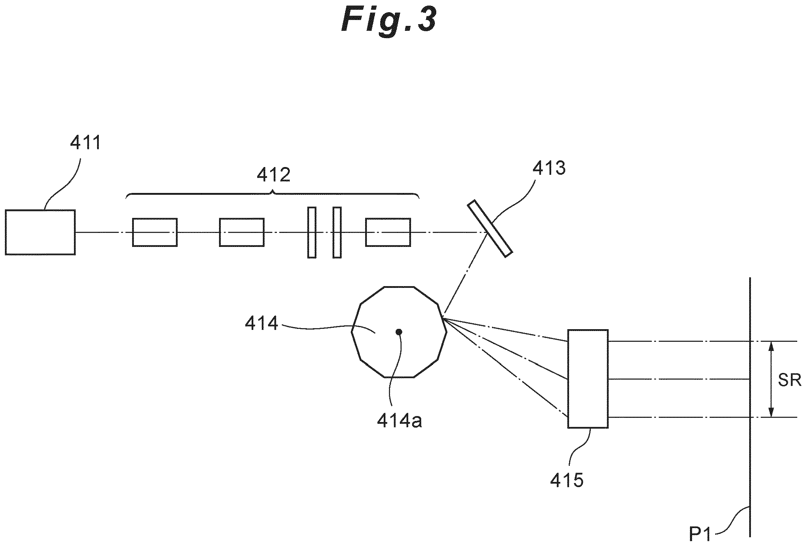

FIG. 3 is a schematic diagram showing a schematic configuration of the inside of an exposure head shown in FIG. 1. As shown in FIG. 3, a laser light source 411 for outputting laser light, a beam-shaping optical system 412, a reflecting mirror 413, a polygon mirror 414, and an imaging optical system 415 are provided inside the exposure head 41. Among which, the polygon mirror 414 is provided with a drive device for rotating the polygon mirror 414 about a rotary shaft 414a.

The beam-shaping optical system 412 includes an optical element, such as a collimator lens, a cylindrical lens, a light amount adjusting filter, and a polarizing filter, and shapes the laser light output from the laser light source 411 into the beam L having a spot-shaped beam shape. The reflecting mirror 413 reflects the beam L shaped by the beam-shaping optical system 412 in the direction of the polygon mirror 414. The polygon mirror 414 rotates around the rotary shaft 414a and reflects the beam L incident from the direction of the reflecting mirror 413 in a plurality of directions in the plane orthogonal to the rotary shaft 414a. The imaging optical system 415 includes an optical element, such as an fθ lens or a telecentric fθ lens, and causes the beam L reflected by the polygon mirror 414 to be imaged on an exposure surface P1 of the substrate 2 supported on the outer periphery of the conveying drum 33. In such exposure head 41, the beam L emitted from the exposure head 41 can be caused to scan one-dimensionally in a predetermined scan range SR by controlling the rotation of the polygon mirror 414.

The configuration of the exposure head 41 is not limited to the configuration illustrated in FIG. 3, as long as the beam L can be imaged on the exposure surface P1 and can be scanned one-dimensionally thereon. For example, the emitting direction of the beam L may be changed by arranging a reflecting mirror between the polygon mirror 414 and the imaging optical system 415. In the following, the longitudinal direction (the direction of conveyance) of the substrate 2 will also be referred to as the x-direction. In addition, the direction orthogonal to such longitudinal direction, i.e., the width direction of the substrate 2, will also be referred to as the y direction. The scan range SR of the beam L is set so as to be parallel to the width direction.

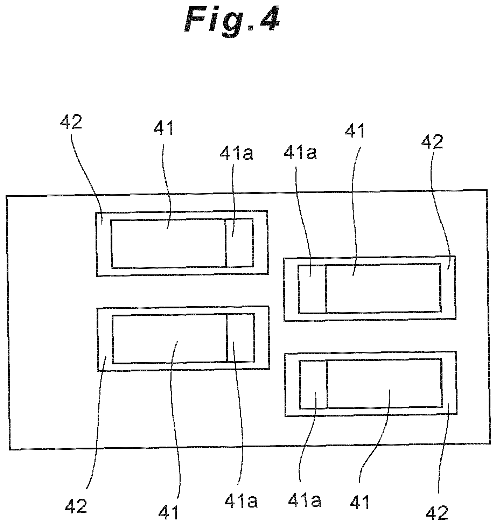

FIG. 4 is a schematic diagram of the plurality of exposure heads 41 provided in the exposure unit 4 as seen from the substrate 2 side. Although four exposure heads 41 are shown in FIG. 4, the number of exposure heads 41 is not limited to four. It is sufficient if the number of exposure heads 41 is one or more, and the number can be appropriately set according to the width of the substrate 2, the scan range SR (see FIG. 3) and the beam power of the exposure head 41, and the like.

Each exposure head 41 is mounted to a support mechanism, which is provided inside the exposure unit 4, via an adjustment stage 42. The adjustment stage 42 is provided for manually fine-adjusting the position of the exposure head 41 in the x and y directions as well as the angle with respect to the vertical direction. By arranging the plurality of exposure heads 41 in the width direction of the substrate 2, a wide range in the width direction of the substrate 2 can be scanned with a plurality of beams L.

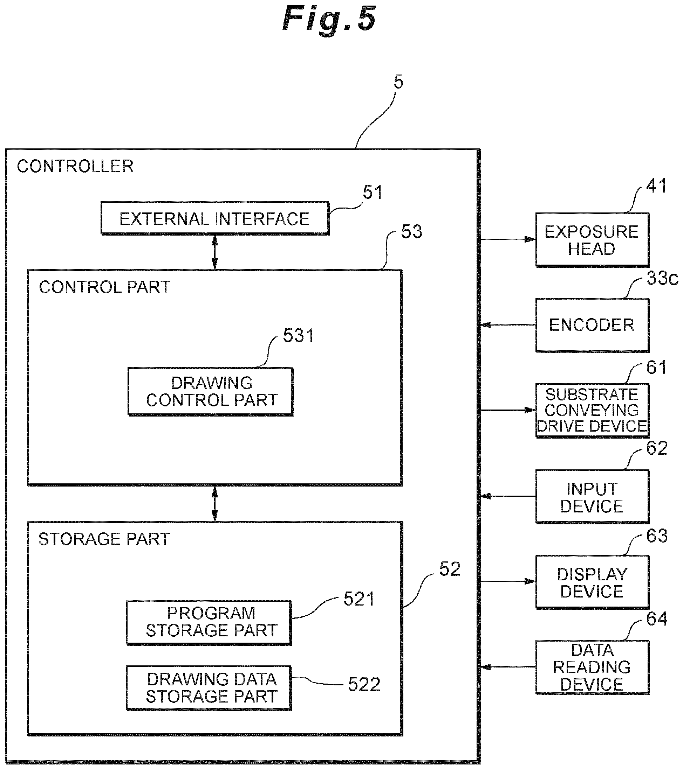

FIG. 5 is a block diagram showing a schematic configuration of the controller 5. The controller 5 is a device for comprehensively controlling the operation of each component of the drawing device 1, and includes an external interface 51, a storage part 52, and a control part 53.

The external interface 51 is an interface for connecting various external devices to the controller 5. Examples of the external devices connectable to the controller 5 include the exposure head 41, the encoder 33c, a substrate conveying drive device 61 for driving the conveying system 3, an input device 62 such as a keyboard, a mouse, or an operation button, a display device 63 such as a liquid crystal monitor, and a data reading device 64 for loading drawing data or the like into the controller 5.

The storage part 52 is configured by using a computer readable storage medium such as a disk drive and/or a solid-state memory (e.g. a ROM or RAM). The storage part 52 stores various types of programs, and/or various types of data, setting information, and the like, used during execution of these programs.

In particular, the storage part 52 includes a program storage part 521 and a drawing data storage part 522. The program storage part 521 stores, in addition to an operating system program and a driver program, a program for causing the controller 5 to execute a predetermined operation, in particular, a drawing program for drawing a continuous long wiring pattern on the substrate 2. The drawing data storage part 522 stores drawing data representing wiring patterns to be drawn by the exposure unit 4.

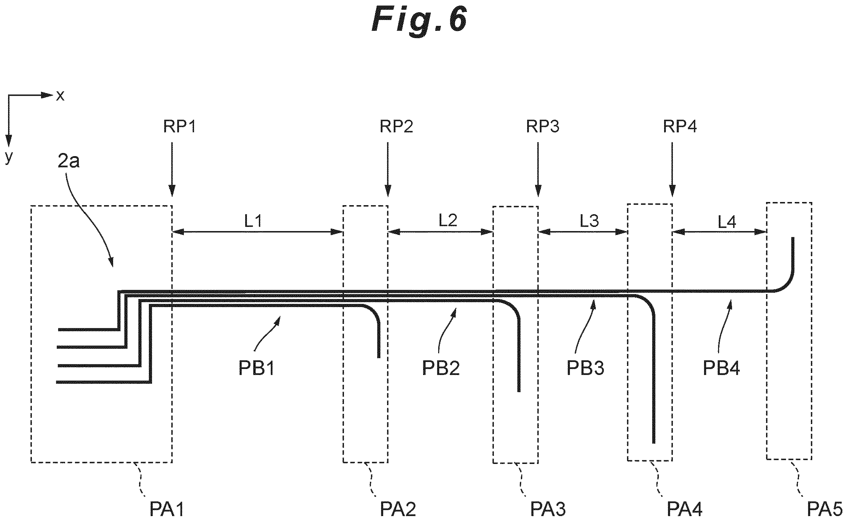

FIG. 6 is a schematic diagram illustrating a wiring pattern to be drawn on the substrate 2. In the present embodiment, a description will be given for the case in which a continuous long pattern, such as the one used as the wiring in, for example, a transportation machine, is drawn. The wiring pattern 2a includes: first regions PA1, PA2, PA3, PA4, and PA5, in which the pattern in the width direction (y direction) of the substrate 2 changes in the longitudinal direction; and second regions PB1, PB2, PB3, and PB4, in which the pattern in the width direction does not change in the longitudinal direction.

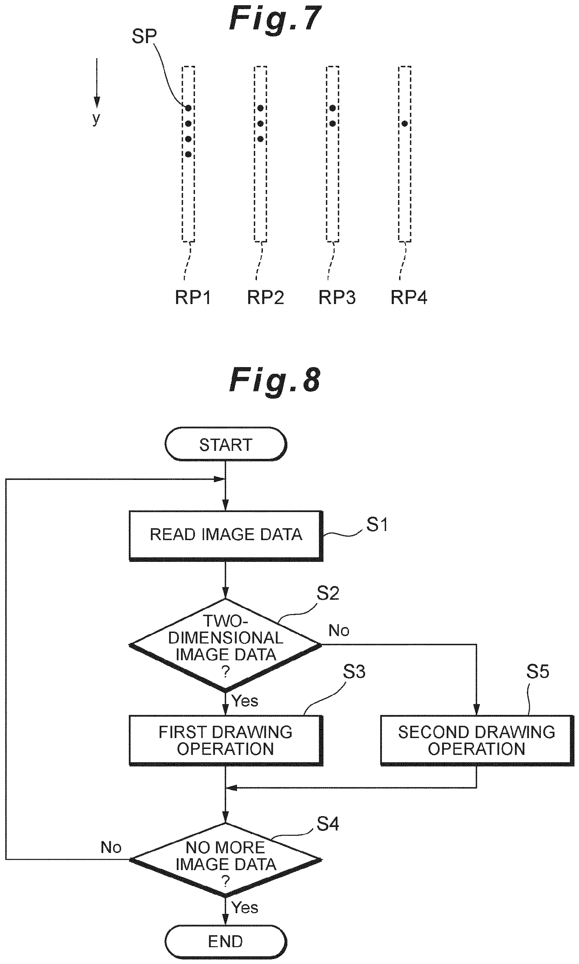

In the present embodiment, the drawing data used to draw wiring pattern 2a on the substrate 2 is composed of image data, which is in a different format between the first regions and the second regions; namely, the patterns of the first regions PA1, PA2, PA3, PA4, and PA5 are represented by two-dimensional image data representing two-dimensional patterns (e.g., two-dimensional bitmap data). On the other hand, the patterns of the second regions PB1, PB2, PB3, and PB4 are represented by: one-dimensional image data representing a one-dimensional pattern in the width direction (e.g., one-dimensional bitmap data); and information representing the longitudinal lengths L1, L2, L3 and L4 of the second regions (e.g., the number of pixels). For example, the information representing the lengths L1, L2, L3, and L4 is attached to the header of the one-dimensional image data corresponding to one-dimensional patterns RP1, RP2, RP3, and RP4 (see FIG. 7).

FIG. 7 is a schematic diagram illustrating one-dimensional patterns in the width direction of the second regions RB1, RB2, RB3, and RB4. The one-dimensional data representing the one-dimensional patterns RP1, RP2, RP3, and RP4 in the width direction of the second regions PB1, PB2, PB3, and PB4 is image data having information on positions in the width direction (y direction) of spots SP to be irradiated with the beams L for exposure. The respective patterns of the second regions PB1, PB2, PB3, and PB4 are drawn based on such one-dimensional image data and the information representing the lengths L1, L2, L3, and L4 of the second regions PB1, PB2, PB3, and PB4.

The control part 53 is configured by using hardware such as a central processing unit (CPU), and reads in the programs stored in the program storage part 521 to perform data transfer and instruction to each component of the controller 5 and the drawing device 1, and comprehensively controls the operation of the drawing device 1 to execute the pattern drawing on the substrate 2.

A functional part implemented by the control part 53 executing the drawing program includes a drawing control part 531. Based on the drawing data read from the drawing data storage part 522, the drawing control part 531 generates control data, such as the power and scanning of the beam L by each exposure head 41, and the conveying speed of the substrate 2 by the conveying system 3, and outputs the control data to the exposure head 41 and the substrate conveying drive device 61. Thereby, the substrate 2 is conveyed at a predetermined speed by the conveying system 3, and a predetermined exposure region of the substrate 2 is irradiated with the beam L emitted from each exposure head 41 and the wiring pattern is drawn on the substrate 2.

In particular, the drawing control part 531 performs control for executing: a first drawing operation, which is based on the two-dimensional image data related to the first regions; and a second drawing operation, which is based on the one-dimensional image data related to the second regions, and the information representing the lengths of such regions. The switching of the drawing operations is performed, for example, based on the information attached to the header of the image data that is read sequentially from the drawing data storage part 522.

As the first drawing operation, the drawing control part 531 performs the control of scanning the beam L in the width direction based on the two-dimensional image data, and conveying the substrate 2. Thereby, the patterns of the first regions PA1, PA2, PA3, PA4, and PA5 are drawn on the substrate 2, wherein the patterns in the width direction of the first regions change in the longitudinal direction.

As the second drawing operation, the drawing control part 531 performs the control of repeatedly irradiating the substrate 2 with the beam L in the one-dimensional pattern in the width direction, the pattern being based on the one-dimensional image data, and conveying the substrate 2 for a length determined based on the information representing the lengths. Thereby, the patterns of the second regions PB1, PB2, PB3, and PB4 are drawn on the substrate 2, wherein the patterns in the width direction of the second regions do not change in the longitudinal direction. In other words, a continuous long pattern is drawn on the substrate 2 along the longitudinal direction over the lengths L1, L2, L3, and L4.

It should be noted that the controller 5 may be configured by a single piece of hardware or may be configured by combining a plurality of pieces of hardware.

FIG. 8 is a flowchart showing a drawing method according to an embodiment of the present invention.

First, the drawing control part 531 sequentially reads the image data from the image data storage part 522 for each region (e.g., the first or second region PA1, PB1, PA2, PB2, ... shown in FIG. 6) configuring the wiring pattern (e.g., the wiring pattern 2a shown in FIG. 6) (step S1). Next, the drawing control part 531 determines whether or not the read image data is two-dimensional image data (step S2).

If the read image data is two-dimensional image data (step S2: Yes), the drawing control part 531 causes each component of the drawing device 1 to perform the above-described first drawing operation. For example, if the two-dimensional image data related to the first region PA1 shown in FIG. 6 is read, the drawing control part 531 performs the control of scanning the beam L emitted from the exposure head 41 in the width direction based on such two-dimensional image data, and conveying the substrate 2.

The drawing control part 531 then determines whether there is no more image data to read next (step S4). If there is more image data to read (step S4: No), the operation of the drawing control part 531 goes back to step S1. If, on the other hand, there is no more image data to read (step S4: Yes), the drawing control part 531 terminates its operation.

In addition, if the read image data is not two-dimensional image data (step S2: No), i.e., if it is one-dimensional image data, the drawing control part 531 causes each component to perform the above-described second drawing operation. For example, if the one-dimensional image data related to the second region PB1 shown in FIG. 6 is read, the drawing control part 531 performs the control of repeatedly irradiating the section of length L1 with the beam L with the one-dimensional pattern RP1 in the width direction that is based on such one-dimensional image data. During this control, the drawing control part 531 may convey the substrate 2 by rotating the conveying drum 33 for a time determined based on the length L1 and the conveying speed of the substrate 2, or may convey the substrate 2 by rotating the conveying drum 33 for a rotation angle determined based on the length L1 and the radius of the conveying drum 33.

In this way, the drawing control part 531 causes each component to execute the first and second drawing operations based on the image data read sequentially from the drawing data storage part 522. More specifically, in the case of the wiring pattern 2a shown in FIG. 6, following the drawing of the second region PB1, the pattern of the first region PA2 is drawn by the first drawing operation, which is based on the two-dimensional image data. Next, the pattern of the second region PB2 is drawn in the section of length L2 by the second drawing operation, which is based on the one-dimensional image data representing the one-dimensional pattern RP2. In a similar manner, the drawing of the pattern of the first region PA3 based on the two-dimensional image data, the drawing of the pattern of the second region PB3 in the section of length L3 based on the one-dimensional image data representing the one-dimensional pattern RP3, the drawing of the pattern of the first region PA4 based on the two-dimensional image data, the drawing of the pattern of the second region PB4 in the section of length L4 based on the one-dimensional image data representing the one-dimensional pattern RP4, and the drawing of the pattern of the first region PA5 based on the two-dimensional image data, are executed in a sequential manner. This allows a long wiring pattern 2a to be formed.

As described above, in the present embodiment, regarding the first regions of the wiring pattern where the pattern in the width direction of the substrate 2 changes in the longitudinal direction, the pattern is drawn by scanning the beam in the width direction based on the two-dimensional image data, and conveying the substrate 2. On the other hand, regarding the second regions where the pattern in the width direction does not change in the longitudinal direction, the pattern is drawn by repeatedly applying the beam for a predetermined length with the one-dimensional pattern in the width direction based on the one-dimensional image data and information representing the lengths of such regions. Therefore, the amount of data in the image data related to the second regions can be significantly reduced compared with the case where the two-dimensional image data representing the two-dimensional pattern as-is is used. Therefore, according to the present embodiment, the amount of data in the drawing data used when exposing a continuous long wiring pattern can be reduced as a whole.

In addition, according to the present embodiment, the patterns of the second regions are formed by repeatedly drawing a one-dimensional pattern continuously in a predetermined section, and a smooth continuous pattern can therefore be formed, unlike the case where an identical two-dimensional pattern is repeatedly drawn by shifting positions. Further, according to the present embodiment, alignment can be dispensed with when forming the patterns of the second regions, which is required in the case where an identical two-dimensional pattern is repeatedly drawn, and the computational load can also therefore be reduced.

The present invention as thus far described is not limited to the above-described embodiments, and various inventions can be formed by appropriately combining a plurality of components disclosed in the above-described embodiments. For example, such various other forms may be formed by excluding some components from all of the components shown in the above-described embodiments, or by appropriately combining the components shown in the above-described embodiments.

### DESCRIPTION OF REFERENCE NUMBERS

1 ... drawing device; 2 ... substrate; 2a ... wiring pattern; 3 ... conveying system; 4 ... exposure unit; 5 ... controller; 31 ... unwinding reel; 32 ... take-up reel; 31a, 32a, 33a, 34a, 36a, 37a ... rotary shafts; 33 ... conveying drum; 33b ... outer periphery; 33c ... encoder; 34, 35 ... tension pulleys; 36, 37 ... guide rollers; 41 ... exposure head; 41a ... beam emitting port; 42 ... adjustment stage; 51 ... external interface; 52 ... storage part; 53 ... control part; 61 ... substrate conveying drive device; 62 ... input device; 63 ... display device; 64 ... data reading device; 411 ... laser light source; 412 ... beam-shaping optical system; 413 ... reflecting mirror; 414a ... rotary shaft; 414 ... polygon mirror; 415 ... imaging optical system; 521 ... program storage part; 522 ... drawing data storage part; 531... drawing control part; PA1, PA2, PA3, PA4, PA5 ... first regions; PB1, PB2, PB3, PB4 ... second regions; RP1, RP2, RP3, RP4 ... one-dimensional patterns

## Claims

1. A drawing method to be executed by a drawing device for drawing a wiring pattern by irradiating a substrate having a long sheet shape with a beam for exposure while conveying the substrate in a longitudinal direction of the substrate,
wherein the drawing device comprises:
conveying means that conveys the substrate along the longitudinal direction; and
at least one head for exposure that is provided opposite to part of a region of the substrate to be conveyed by the conveying means and that emits a beam for exposure toward the part of the region of the substrate,
wherein the wiring pattern includes first regions, in which a pattern in a width direction orthogonal to the longitudinal direction changes in the longitudinal direction, and second regions, in which a pattern in the width direction does not change in the longitudinal direction,
wherein drawing data for drawing the wiring pattern includes two-dimensional image data representing a two-dimensional pattern of the first regions, one-dimensional image data representing a one-dimensional pattern in the width direction of the second regions, and information representing lengths in the longitudinal direction of the second regions,
the method comprising:
drawing the pattern of the first regions on the substrate by scanning the beam in the width direction based on the two-dimensional image data and conveying the substrate; and
drawing the pattern of the second regions on the substrate by repeatedly irradiating the substrate with the beam in the one-dimensional pattern in the width direction based on the one-dimensional image data and conveying the substrate for a length determined based on the information representing lengths.

2. The drawing method according to claim 1, wherein the two-dimensional image data is a two-dimensional bitmap data,
wherein the one-dimensional image data is one-dimensional bitmap data, and
wherein the information representing lengths is attached to a header of the one-dimensional bitmap data.

3. The drawing method according to claim 1 or 2, wherein the conveying means has a cylindrical shape, and includes a conveying drum that supports the substrate on part of a region of an outer periphery and conveys the substrate by rotating about a central shaft of the cylinder, and
wherein the conveying drum rotates for a time or a rotation angle, which is determined based on the information representing lengths, while the beam is repeatedly applied based on the one-dimensional image data.

4. The drawing method according to any one of claims 1 to 3, comprising: reading image data included in the drawing data for drawing the wiring pattern for each region included in the wiring pattern;
determining whether the read image data is either the two-dimensional image data or the one-dimensional image data; and
drawing the pattern of the first regions or the second regions depending on the result of the determination.

5. A drawing device for drawing a wiring pattern by irradiating a substrate having a long sheet shape with a beam for exposure while conveying the substrate in a longitudinal direction of the substrate, comprising:
conveying means that conveys the substrate along the longitudinal direction;
at least one head for exposure that is provided opposite to part of a region of the substrate to be conveyed by the conveying means and that emits a beam for exposure toward the part of the region of the substrate;
a storage part that stores drawing data for drawing the wiring pattern on the substrate; and
a control part that controls operations of the at least one head for exposure and the conveying means based on the drawing data,
wherein the wiring pattern includes first regions, in which a pattern in a width direction orthogonal to the longitudinal direction changes in the longitudinal direction, and second regions, in which a pattern in the width direction does not change in the longitudinal direction,
wherein drawing data includes two-dimensional image data representing a two-dimensional pattern of the first regions, one-dimensional image data representing a one-dimensional pattern in the width direction of the second regions, and information representing lengths in the longitudinal direction of the second regions,
wherein the control part performs the control of executing:
a first drawing operation of drawing the pattern of the first regions on the substrate by scanning the beam in the width direction based on the two-dimensional image data and conveying the substrate, and
a second drawing operation of drawing the pattern of the second regions on the substrate by repeatedly irradiating the substrate with the beam in the one-dimensional pattern in the width direction based on the one-dimensional image data and conveying the substrate for a length determined based on the information representing lengths.

6. A drawing program to be executed by a drawing device for drawing a wiring pattern by irradiating a substrate having a long sheet shape with a beam for exposure while conveying the substrate in a longitudinal direction of the substrate,
wherein the drawing device comprises:
conveying means that conveys the substrate along the longitudinal direction; and
at least one head for exposure that is provided opposite to part of a region of the substrate to be conveyed by the conveying means and that emits a beam for exposure toward the part of the region of the substrate,
wherein the wiring pattern includes first regions, in which a pattern in a width direction orthogonal to the longitudinal direction changes in the longitudinal direction, and second regions, in which a pattern in the width direction does not change in the longitudinal direction,
wherein drawing data for drawing the wiring pattern includes two-dimensional image data representing a two-dimensional pattern of the first regions, one-dimensional image data representing a one-dimensional pattern in the width direction of the second regions, and information representing lengths in the longitudinal direction of the second regions,
wherein the drawing program causes the execution of:
a first drawing step of drawing the pattern of the first regions on the substrate by scanning the beam in the width direction based on the two-dimensional image data and conveying the substrate; and
a second drawing step of drawing the pattern of the second regions on the substrate by repeatedly irradiating the substrate with the beam in the one-dimensional pattern in the width direction based on the one-dimensional image data and conveying the substrate for a length determined based on the information representing lengths.
